# EUROPEAN PATENT APPLICATION

(11) **EP 2 711 982 A2**
(43) Date of publication of application: **26.03.2014**
(21) Application number: 13183731.2
(22) Date of filing: 10.09.2013
(51) Int. Cl.: H01L 23/34

(54) **Method and apparatus for pre-emptive power semiconductor module fault indication**

(30) Priority: 19.09.2012 US 201213622688
(71) Applicant: ABB Oy, 00380 Helsinki (FI)
(72) Inventor: Tiihonen, Vesa, 00380 Helsinki (FI); Tikkanen, Kari, 00380 Helsinki (FI)
(74) Representative: Kolster Oy Ab

(57) **Abstract**

A method and an apparatus for an arrangement including a power semiconductor module with a cooling interface which is connected to a cooling element. The method first measures a first temperature value of the cooling interface, and then changes an operating mode of the power semiconductor module, wherein the operating mode is selected from an active mode and an inactive mode. The method then waits a determined time, measures a second temperature value of the cooling interface, and determines a temperature difference between the first temperature value and the second temperature value. The method then determines a level of a fault risk on the basis of the temperature difference. The apparatus implements the method.

## Description

### FIELD

The present disclosure relates to a method and apparatus for monitoring power semiconductor modules, and more particularly, to pre-emptively detecting faults.

### BACKGROUND INFORMATION

Modern power semiconductors are not ideal. They produce losses which manifest themselves in heat. This heat can cause overheating, which, in turn, can cause in a failure in the power semiconductor. For this reason, power semiconductors typically require cooling during operation.

Power semiconductors can be arranged into power semiconductor modules, such as, insulated gate bipolar transistor (IGBT) modules, which can include semiconductors configured into an inverter bridge leg or a whole inverter bridge. The power semiconductor module can also include a cooling interface. For example, semiconductors can be mounted on a thermally conductive base plate in a module in order to provide a path for transferring heat from the semiconductors. The base plate can then be connected to a cooling element.

The cooling element transfers heat from the power semiconductor module to, for example, a flow of air. The cooling element can be dimensioned such that the power semiconductor module does not overheat under normal operating conditions.

Even if the cooling of a module is properly arranged, a fault in the power semiconductor module or in the thermal coupling between the module and the cooling element may cause the module to overheat. In order to avoid overheating and further damage, the temperature of the power semiconductor module can be monitored. If the temperature of the module exceeds a set maximum temperature limit, the module can be set to an inactive operating mode.

However, the above presented method does not protect the module from the fault causing overheating. The maximum temperature limit may have to be set such that it is not exceeded when operating at a maximum current under normal operating conditions. Different ambient temperatures may also have to be considered when deciding the maximum temperature limit. Also, if more than one power semiconductor module is connected to the same cooling element, temperature monitoring of one module can be affected by the others. As a result, the limit may have to be set so high that only a clear fault can cause a temperature which exceeds the limit.

### SUMMARY

An exemplary embodiment of the present disclosure provides a method for an arrangement including a power semiconductor module with a cooling interface which is connected to a cooling element. The exemplary method includes measuring a first temperature value of the cooling interface, and changing an operating mode of the power semiconductor module, wherein the operating mode is selected from an active mode and an inactive mode. The exemplary method also includes waiting a determined time, measuring a second temperature value of the cooling interface, determining a temperature difference between the first temperature value and the second temperature value, and determining a level of a fault risk on the basis of the temperature difference.

An exemplary embodiment of the present disclosure provides an apparatus for an arrangement including a power semiconductor module with a cooling interface which is connected to a cooling element. The exemplary apparatus includes means for measuring a first temperature value of the cooling interface, and means for changing an operating mode of the power semiconductor module, wherein the operating mode is selected from an active mode and an inactive mode. The exemplary apparatus also includes means for measuring a second temperature value of the cooling interface after a determined period of time from when the operating mode was changed, means for determining a temperature difference between the first temperature value and the second temperature value, and means for determining a level of a fault risk on the basis of the temperature difference.

### BRIEF DESCRIPTION OF THE DRAWINGS

Additional refinements, advantages and features of the present disclosure are described in more detail below with reference to exemplary embodiments illustrated in the drawings, in which:

Figure 1 illustrates an exemplary arrangement where a power semiconductor module is mounted on a cooling element; and

Figures 2a and 2b illustrate exemplary situations where an operating mode of a power semiconductor module is changed.

### DETAILED DESCRIPTION

Exemplary embodiments of the present disclosure provide a method and an apparatus for implementing the method so as to alleviate the above drawbacks.

In order to transfer heat from an active module producing heat, a cooling element thermally coupled to the module has a lower temperature than the module. A temperature difference remains between the module and the cooling element. Power losses of the module and thermal properties of the thermal coupling can affect the temperature difference.

According to an exemplary embodiment, the method of the present disclosure monitors this temperature difference. An elevated temperature difference can be used to pre-emptively detect a possible fault. The temperature difference can be compared with a nominal temperature calculated on the basis of estimated theoretical losses at a present operation point of the power semiconductor module.

The temperature difference can be determined by using one temperature sensor which measures the temperature of a cooling interface of the power semiconductor module. The cooling interface, such as a base plate, has a small mass as compared with that of a cooling element cooling the module. Thus, the cooling interface cools down and heats up much faster than the cooling element. The temperature of the cooling element can be considered to be constant in the method according to the present disclosure.

The temperature difference can therefore be determined by first measuring the temperature in an active (heat-producing) mode. The module can then be set to an inactive (non-heat-producing) mode. After the temperature of the cooling interface has settled at the temperature of the cooling element, the temperature of the cooling interface can be measured again, thus determining the temperature difference. Alternatively, the difference can be determined in a transition from the inactive mode to the active mode.

The disclosed method allows a pre-emptive detection of some power semiconductor module related faults. An effect of the ambient temperature can be ignored as the temperature of the module is measured with respect to the cooling element. The method can operate with one temperature sensor per module.

The method of the present disclosure can be implemented in an arrangement including a power semiconductor module with a cooling interface which is connected to a cooling element. The method first measures a first temperature value of the cooling interface and changes an operating mode of the power semiconductor module, wherein the operating mode can be selected from an active mode and an inactive mode.

An active mode, in this context, refers to an operational mode which produces heat. For example, a mode in which (i) switching devices in the power semiconductor module switch and/or (ii) the semiconductors in the module conduct current can be seen as an active mode. The switching causes switching losses and the flow of current causes conductive losses.

An operational mode in which no switching device switches and no semiconductor in the module conducts current can be used as an example of an inactive mode. In other words, in an inactive mode, the module does not produce heat.

After changing the operating mode, the method waits a determined time, and measures a second temperature value at the cooling interface. The method then determines a temperature difference between the first temperature value and the second temperature value, and then, determines a level of a fault risk on the basis of the temperature difference.

For example, the disclosed method can determine weakening of a thermal connection between the cooling interface plate and the cooling element.

The method can also determine a decrease in a gate voltage of the power semiconductor module. A low gate voltage may, for example, indicate a problem in the gate driver of the module or in the module itself.

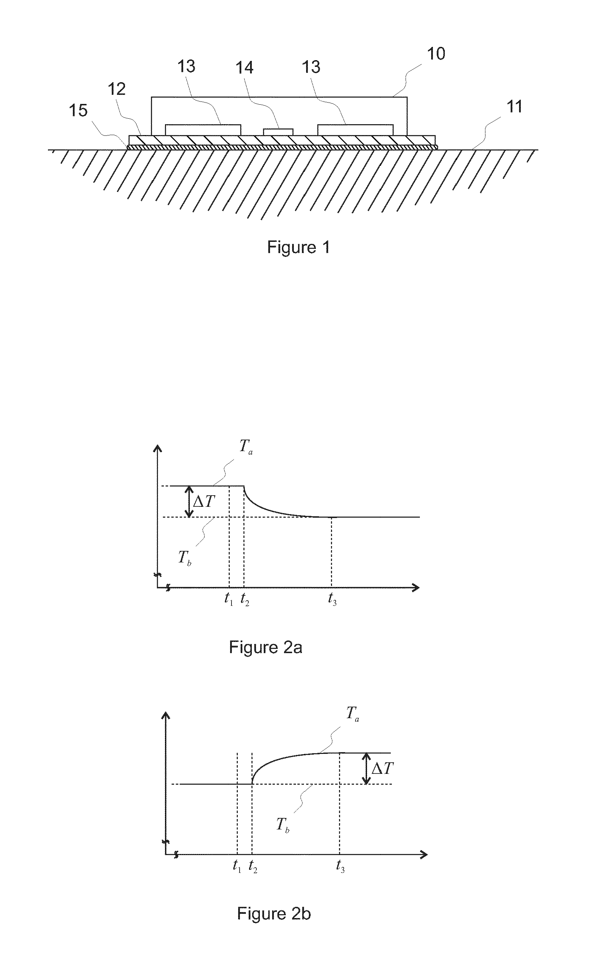

Figure 1 illustrates an exemplary arrangement where a power semiconductor module 10 is mounted on a cooling element 11. In the example of Figure 1, the power semiconductor module is an IGBT module, and the cooling element 11 is a heat sink. The IGBT module is provided with a base plate 12 onto which power semiconductors 13 are mounted. The base plate 12 serves as the cooling interface of the module 10. A temperature sensor 14 is also mounted on the base plate 12. The disclosed method is not limited to arrangements where the module 10 has a base plate. The disclosed method can also be used with other kind of power semiconductor modules.

The module 10 is connected to the heat sink 11 by its base plate 12. A layer of thermal paste 15 is placed between the base plate 12 and the heat sink 11 in order to ensure a good thermal coupling between the base plate 12 and the heat sink 11.

When the module 10 produces heat, and the heat sink 11 cools the module 10 down, a temperature difference remains between them. This difference may, for example, be 5 to 10 degrees Celsius. Power losses in the module 10 and thermal properties of the thermal coupling can affect the temperature difference.

A frequency converter (not shown in Figure 1) controlling the module 10 can, for example, be used as an apparatus for implementing the method of the present disclosure. Alternatively, a separate apparatus can be used. First, the apparatus uses the temperature sensor 14 to measure a first temperature value of the cooling interface (e.g., the base plate 12).

Then, the operating mode of the power semiconductor module 10 can be changed. The apparatus includes means for changing the operating mode. For example, if the apparatus implementing the disclosed method is, for example, a frequency converter, it can change the operating mode.

The disclosed method can, for example, be applied when changing the operating mode from active to inactive. Figure 2a illustrates an exemplary situation where the operating mode of the module 10 of Figure 1 is changed from active to inactive.

The first value of the base plate 12 temperature *Tₐ* is measured at time *t*₁.

At time *t*₂ in Figure 2a, the operating mode is changed from active to inactive. The base plate 12 in Figure 1 has a small mass as compared with that of the heat sink 11. Thus, the base plate 12 cools down and heats up much faster than the heat sink 11. The temperature of the heat sink 11 can be considered to stay constant. Since the module 10 no longer produces heat, the temperature *Tₐ* of the base plate 12 starts rapidly decreasing towards the temperature *T_{b}* of the heat sink 11. The temperature *Tₐ* can reach the temperature *T_{b}* within a few seconds, for example.

The apparatus can then wait a determined time. The time may, for example, be selected such that the temperature *Tₐ* of the base plate 12 is able to settle near the temperature *T_{b}* of the heat sink 11. In Figure 2a at time *t*₃*,* it is assumed that the temperature *Tₐ* of the base plate 12 is approximately the temperature *T_{b}* of the heat sink 11, and a second value of temperature *Tₐ* of the base plate is measured by using the temperature sensor 14.

The method can also be applied to a situation wherein the operating mode is changed from inactive to active. Figure 2b illustrates an exemplary situation where the operating mode of the module 10 of Figure 1 is changed from inactive to active.

In Figure 2b, at time *t*₁, the first value of the base plate 12 temperature *Tₐ* is measured by using the temperature sensor 14.

The operating mode is changed from inactive to active at time *t*₂. In a start-up situation, the losses may be too low for producing a temperature difference which could be used by the disclosed method. However, the switching frequency during the method can be configured for inducing switching losses to produce reliable temperature difference measurements. In other words, increasing the switching frequency can increase losses in the module.

After the operating mode has been changed into the active mode, the temperature *Tₐ* of the base plate 12 increases above the temperature *T_{b}* of the heat sink 11.

The apparatus then waits a determined time so that the temperature *Tₐ* of the base plate 12 can settle at its final level. In Figure 2b, at time *t*₃*,* the temperature *Tₐ* of the base plate 12 is settled, and a second value of the temperature *Tₐ* of the base plate is measured by using the temperature sensor 14.

When the first and the second temperature value have been measured, the apparatus can then determine a temperature difference Δ*T* between the first temperature and the second temperature, and determine a level of a fault risk on the basis of the temperature difference Δ*T*. If the apparatus is a frequency converter, for example, determining the temperature difference and the level of the fault risk can, for example, be accomplished on the control card (e.g., processor) of the frequency converter.

The fault risk level can be calculated from the temperature difference Δ*T*. Determining the fault risk level can, for example, include setting a temperature limit, comparing the determined temperature difference with the temperature limit, and indicating an elevated fault risk level if the determined temperature difference Δ*T* exceeds the temperature limit.

The temperature limit may be a fixed limit or it may depend on the present operating point. The set temperature limit can, for example, be a fixed limit which can be determined during production testing of the power semiconductor module. The temperature limit can also be a nominal temperature, which can be calculated on the basis of estimated theoretical losses at the present operation point of the power semiconductor module.

Alternatively, an initial temperature difference value during production testing under certain operating conditions can be measured and stored. The stored value can then be used as a reference with which later measured temperature differences are compared. If a difference between temperature differences reaches a set level, an elevated fault risk level can be indicated.

The fault risk level can also be calculated from the temperature difference Δ*T* together with the determined time. The fault risk level can be determined by first setting a limit for a rate of change in the temperature. The rate of change can then be determined on the basis of the temperature difference and the determined time. For example, the rate of change can then be determined by dividing the temperature difference by the determined time. Next, the rate of change can be compared with the set limit, and an elevated fault risk level can be indicated if the determined rate of change in the temperature exceeds the set limit.

The disclosed method and apparatus can also be utilized in arrangements including a plurality of power semiconductor modules which are connected to the same cooling element. The method can, for example, determine the temperature differences of a plurality of power semiconductor modules. The temperature differences can be determined in a manner similar to that disclosed above. The temperature differences can then be used to determine at least one deviation between the temperature differences. A level of a fault risk can then be determined on the basis of the at least one deviation. An increased deviation can, for example, be used to detect an uneven distribution of current in parallel-connected modules. Thus, the disclosed method can, for example, be used to determine if a module was successfully changed during a maintenance break. This can reduce unnecessary temperature trips in parallel-connected modules.

It will be obvious to a person skilled in the art that the inventive concept can be implemented in various ways. The disclosure and its embodiments are not limited to the examples described above but may vary within the scope of the claims.

It will be appreciated by those skilled in the art that the present invention can be embodied in other specific forms without departing from the spirit or essential characteristics thereof. The presently disclosed embodiments are therefore considered in all respects to be illustrative and not restricted. The scope of the invention is indicated by the appended claims rather than the foregoing description and all changes that come within the meaning and range and equivalence thereof are intended to be embraced therein.

## Claims

1. A method for an arrangement including a power semiconductor module with a cooling interface which is connected to a cooling element, the method comprising:
measuring a first temperature value of the cooling interface;
changing an operating mode of the power semiconductor module,
wherein the operating mode is selected from an active mode and an inactive mode;
waiting a determined time after the operating mode has been changed;
measuring a second temperature value of the cooling interface;
determining a temperature difference between the first temperature value and the second temperature value; and
determining a level of a fault risk on the basis of the temperature difference.

2. A method according to claim 1, wherein the determining of the fault risk level comprises:
setting a temperature limit;
comparing the determined temperature difference with the temperature limit; and
indicating an elevated fault risk level if the determined temperature difference exceeds the temperature limit.

3. A method according to claim 1, wherein the determining of the fault risk level comprises:
setting a limit for a rate of change of the temperature;
determining the rate of change on the basis of the temperature difference and the determined time;
comparing the determined rate of change with the set limit; and
indicating an elevated fault risk level if the determined rate of change difference exceeds the set limit.

4. A method according to claim 2, wherein the temperature limit is a nominal temperature calculated on the basis of estimated theoretical losses at a present operation point of the power semiconductor module.

5. A method according to claim 2, wherein the temperature limit is determined during production testing of the power semiconductor module.

6. A method according to claim 1, wherein the arrangement comprises a plurality of power semiconductor modules, and
wherein the method comprises:
determining the temperature differences of a plurality of the power semiconductor modules;
determining at least one deviation between the temperature differences;
and
determining a level of a fault risk on the basis of the at least one deviation.

7. A method according to claim 1, wherein the cooling interface is a base plate.

8. A method according to claim 1, wherein the method is applied when changing the operating mode from active to inactive.

9. A method according to claim 1, wherein the method is applied when changing the operating mode from inactive to active.

10. A method according to claim 7, wherein a switching frequency in the active operating mode during the method is configured for inducing switching losses to produce reliable temperature difference measurements.

11. A method according to claim 1, comprising:
determining weakening of a thermal connection between the cooling interface plate and the cooling element.

12. A method according to claim 1, comprising:
determining a decrease in a gate voltage of the power semiconductor module.

13. An apparatus for an arrangement including a power semiconductor module with a cooling interface which is connected to a cooling element, the apparatus comprising:
means for measuring a first temperature value of the cooling interface;
means for changing an operating mode of the power semiconductor module, wherein the operating mode is selected from an active mode and an inactive mode;
means for measuring a second temperature value of the cooling interface after a determined period of time from when the operating mode has been changed;
means for determining a temperature difference between the first temperature value and the second temperature value; and
means for determining a level of a fault risk on the basis of the temperature difference.

14. The apparatus according to claim 13, wherein the apparatus includes a frequency converter.
